# EUROPEAN PATENT SPECIFICATION

(11) **EP 0 940 309 B1**
(45) Date of publication and mention of the grant of the patent: **19.02.2003**
(21) Application number: 99108213.2
(22) Date of filing: 21.06.1995
(51) Int. Cl.: B60R 25/04, H01M 2/34

(54) **Battery comprising a electrically controlled switch means**
Batterie mit einem elektrischen Kontrollschalter
Batterie avec interrupteur électronique

(30) Priority: 22.06.1994 SE 9402216
(43) Date of publication of application: 08.09.1999
(62) Divisional of application: 95850115.7
(73) Proprietor: Intra International AB, 412 50 Göteborg (SE)
(72) Inventor: Thomsen, Jes, 2300 Copenhagen S (DK); Rehnberg, Tore, 440 41 Nol (SE)
(74) Representative: Rosenquist, Per Olof

(56) References cited:
- EP-A- 0 023 280
- GB-A- 2 263 012
- US-A- 5 023 591

## Description

### TECHNICAL FIELD

The present invention relates to a battery which is protected against theft and in particularly to the electrical and mechanical connection of control circuits and to the electrical current supply lines thereof.

### BACKGROUND OF THE INVENTION

Motor vehicles having internal combustion engines are most often started by means of an electrically powered starter motor which obtains its powering current from a battery which in the conventional way comprises several electrochemical battery cells containing plates submerged in an electrolyte. The battery is connected to the starter motor by means of a switch in an ignition lock which is switched on at turning a key.

It is however relatively difficult to protect such a conventional system against theft since the switch in the ignition lock can be by-passed in a simple manner. There is thus a need for alternative ways of protecting motor vehicles against theft. A possibility therefor is arranging a protection against theft directly in or at the battery as will be apparent from the discussion below.

### STATE OF THE ART

The published British patent application GB-A 2263012 for David John Cuckow et al. discloses an anti-theft battery comprising an electrical switch 2, S placed inside the battery vessel 8 below the level of the electrolyte 6.

The published International patent application WO-A1 94/01894 for B.I.G. Batteries Limited/Peter Philip Gatehouse discloses a security battery for motor vehicles comprising an electronic circuit board 8 comprising a control circuit arranged inside the lid of the battery, above an interior lid 11 placed above the cells.

The published European patent application EP-A2 0 163 822 for Sociedad Espanola del Acumulador Tudor, S.A., discloses an electrical starter battery comprising electronic circuits arranged in a lid of the battery.

### DESCRIPTION OF THE INVENTION

It is an object of the invention to provide a battery which is protected or protects against theft, in which a switch is mounted having a good thermal dissipation.

It is a further object to provide an anti-theft battery comprising that connector pieces and wires from the individual battery cells are prolonged in a way which gives a low total weight of the battery.

It is a further object to provide a practical arrangement for installing electrical lines to control circuits in an anti-theft battery.

The objects mentioned are achieved by the invention, the features and characteristics of which appear from the following description and the appended claims.

In the lid of a battery, in the preferred case a lead-acid battery, a theft protection device is provided comprising a switch device and control circuits. In order to achieve a good heat dissipation from the switch device it is in a direct contact with metal plates attached to terminals in individual battery cells, i.e. in two cells connected in series, in those two terminals which otherwise would be permanently connected. These terminals can in one embodiment be located at the same long side of the battery as the outermost terminals, what in certain cases is provided by arranging a connection deviating from the conventional arrangement of these battery cells and the adjacent cells. From the outermost terminals pole pieces can extend to longitudinal channels which extend up to a cavity for the switch device and the control circuits. In these channels then electrical lines are arranged to the control circuits and in particular to a power supply unit.

A battery comprising a theft protecting device comprises in the conventional way several cells which are connected to each other in series. In each cell positive and negative battery plates are provided and they are connected by positive and negative plate strap connectors, which each one forms a terminal of the cell. An electrically controlled switch is connected between two adjacent cells which are connected in series and is thus connected instead of the normal connection in series between these cells, i.e. is connected to a positive terminal of a cell and a negative terminal of an adjacent cell. Control circuits act on' the switch for bringing it into a closed state, where none or a very little current can be drawn from the battery. Such a switch can in a conducting state develop quite a lot of energy from the residual resistance therein and this energy in the form of heat can be dissipated by arranging the switch also in a good thermal contact with those terminals to which the switch is electrically connected. Therefore the switch is at least partly attached onto an electrically and thermally conducting plate and one electrical terminal of the switch comprises a surface contacting this plate. The terminals of the switch can thus comprise conducting metal parts having bottom surfaces which form such a connection. The plate is then in turn in an electrical and intimate thermal contact with one of said terminals.

The terminal with which the plate is in contact can be prolonged by a pole piece for facilitating the disposition and connection of the switch. This terminal or the pole piece, with which the plate is in contact, has advantageously a substantially flat top surface, to which the plate is attached. On both of the mentioned terminals such plates and pole pieces can be arranged.

The terminals to which the switch is connected can have upstanding pole posts which extend up from a plate connector, that is a connection element between plates of the same polarity in a cell, the pole posts comprising a rotationally symmetric rod, in particular a circular cylindrical rod or having the shape of a frustum of circular cone having a small cone angle. Then, a pole piece is at its one end attached to this rod through a rotationally symmetric, in particular circular cylindrical or conical, hole adapted to the rod. At its other end the pole piece is attached to and connected to the electrically controlled switch. Such an arrangement makes it possible to turn the pole pieces around the pole post when mounting them on the terminals, so that a desired distance can be obtained between those points, where the pole pieces are connected to the switch or to the conducting plates to which the switch is connected. An attachment of the pole pieces to the pole posts can be achieved by a weld at one edge of the holes which are adapted to the pole post rods. The rods can further have such a length so that their end surfaces are located essentially in the same plane as a top surface of the pole pieces, in order to make it possible that the pole pieces will obtain an essentially flat top surface.

The battery has as conventional the plates in all cells arranged essentially parallel to each other and external terminals, from which useful current can be drawn. If all of the cells are essentially identical, the battery will then have the shape of a substantially rectangular body having a longitudinal direction perpendicular to the plates. In order to make it possible that the switch and the control circuits thereof are mounted having short exterior connections they should be located at the long side of the battery which is parallel to the longitudinal direction and is located adjacent the external terminals, where this side can be designated as the front side of the battery. Therefore in this case the external terminals and the mentioned positive terminal and the negative terminal, to which the switch is connected, should be located at this long side or generally all be located at the same side of a central line extending in the longitudinal direction of the battery.

All terminals of the battery cells except the terminals of those cells where the switch means is connected, and one terminal of the cells, which are located adjacent thereto, can in this case be placed and connected to each other in the conventional way in a zigzag pattern and the terminals and plate connectors of the other cells can be constructed with centre connections.

In conventional lead-acid batteries for 12 V there are six cells and then the switch means is preferably connected between the two middle adjacent cells, i.e. having its terminals connected to a positive terminal of a middle cell and to a negative terminal of the adjacent middle cell.

The electrical control circuit for the switch means requires itself a supply of electrical current for the operation thereof and can therefor through electrical conductors be electrically connected to the external terminals of the battery for having its energy supply therefrom in the normal case, from the entire battery and all cells. These conductors can then be arranged in channels in the lid, which extend in the longitudinal direction of the battery perpendicularly to the battery plates, and further additional pole pieces can be attached to the external terminals. These will then extend essentially parallel to the battery plates into the channels, where they are electrically connected to the conductors. In this way short additional pole pieces can be used, which, if constructed by lead as is the case for a lead-acid accumulator, still have a significant weight.

Often the lid is provided with inspection plugs, one located above each battery cell, which are connected by a degassing channel, which extends in the longitudinal direction of the battery, and then the channels for the electrical conductors are advantageously located next to the degassing channel or at least between the degassing channel and the external terminals, so that no long, heavy portions of the pole pieces are required for passing below the degassing channel.

In the case where such channels for the conductors are provided, they can be open or openable at their outer ends. The connection between the additional pole pieces in the conductors can then be made accessible.

### DESCRIPTION OF THE DRAWINGS

The invention will now be described in more detail with reference to non-limiting embodiments and with reference to the accompanying drawings, in which:
- Fig. 1 is a view from above of a battery protected against theft, where the lid is partly removed over a cavity for switch and control circuits,
- Fig. 2 is a sectional view along the line II-II in Fig. 1 of the upper portion of the battery,
- Fig. 3 is a sectional view along the line III-III in Fig. 1,
- Fig. 4 is a sectional view along the line IV-IV in Fig. 1,
- Fig. 5 is a view from above of a conventional battery having its lid removed,
- Fig. 6 is a view from above of a battery having its lid removed, where the connection between battery cells is modified,
- Fig. 7 is a view from above of a battery which is protected against theft and has an other disposition of switch and control circuits, where a cover plate is removed,
- Fig. 8 is a view from above of a battery vessel having its lid removed and suitable for the embodiment according to Fig. 7.

### DESCRIPTION OF PREFERRED EMBODIMENTS

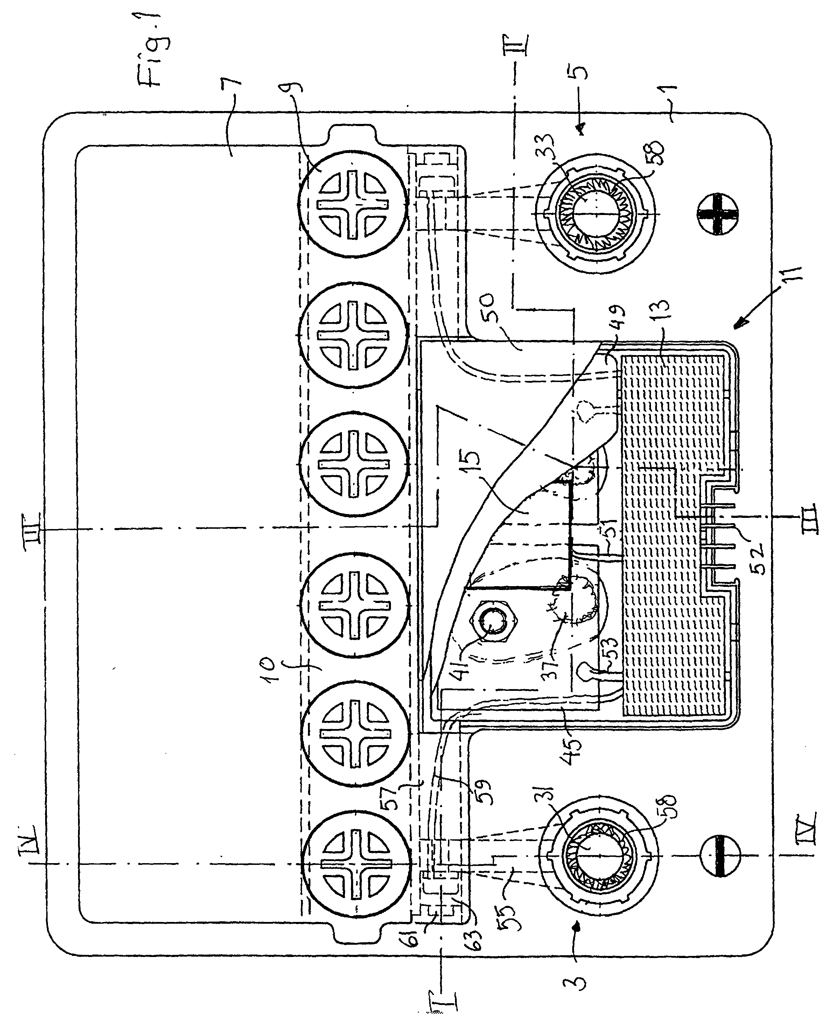

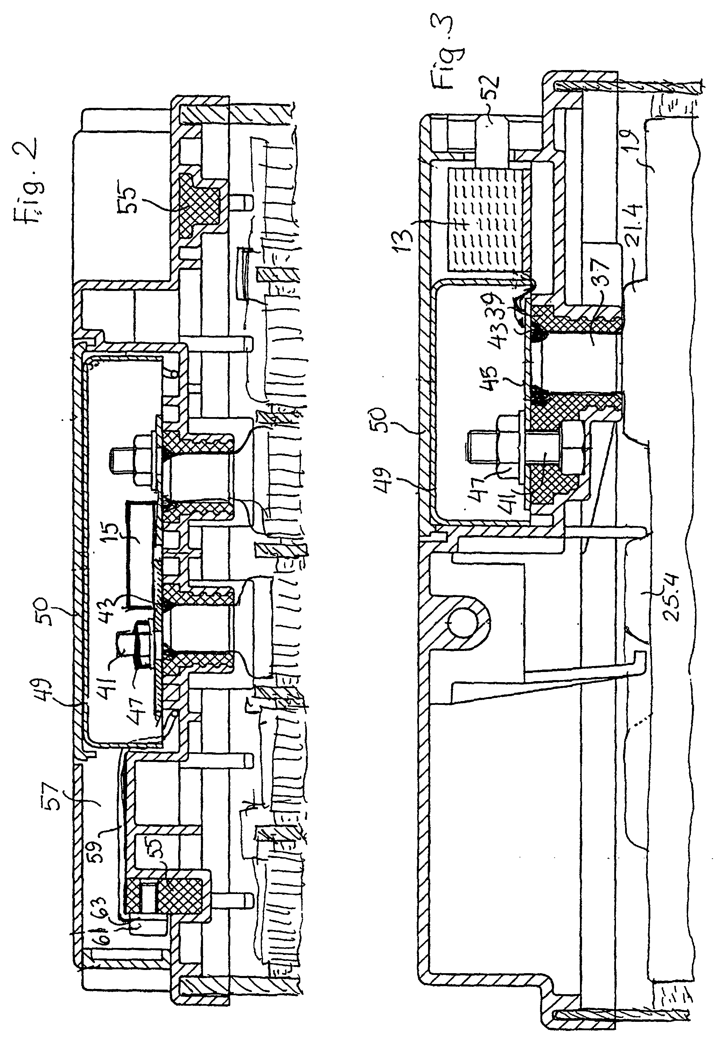

Fig. 1 is a plan view of a battery, which is provided with an anti-theft circuit. In Fig. 1 a lid of the battery is seen having a negative, external or outermost battery terminal 3 and a positive, external or outermost battery terminal 5. The polarity is indicated by marks on the top side of the lid in the vicinity of the respective battery terminal 3, 5. As appears from the sectional view of Fig. 3 the rear part 7 of the upper portion or lid of the battery is elevated in relation to those portions, where the external terminals 3 and 5 of the battery are located. In this rear upper portion 7 plugs 9 are screwed into corresponding threads in the lid above each individual battery cell and they are located above a degassing channel 10, which extends in the longitudinal direction of the battery and connects the spaces above the battery cells to each other. The plugs 9 can be screwed out for checking the electrolyte level in the individual cells. Between the external battery terminals 3 and 5, at the front portion of the battery also an elevated portion 11 is provided, the topmost part of which is located in the same plane as the rear portion 7. In this front elevated portion 11 electronic circuits are provided for control of the battery, the circuits being encapsulated in a tight and hard plastics material, shown at 13. A switch device 15 is also arranged in this portion 11 and is connected between the middle cells of the battery, which are connected in series, see also the circuit diagram of Fig. 9.

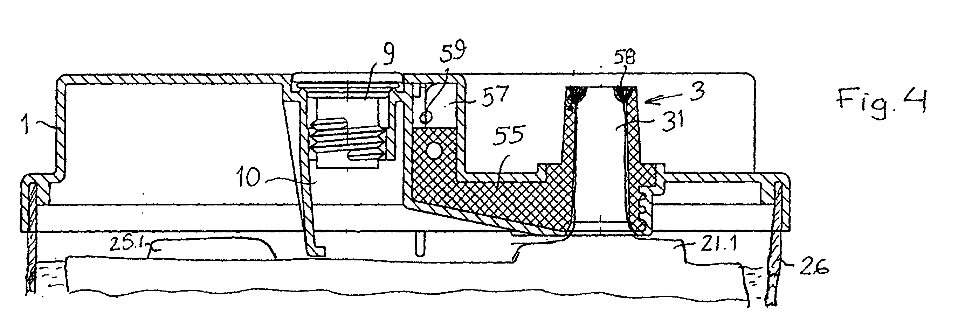

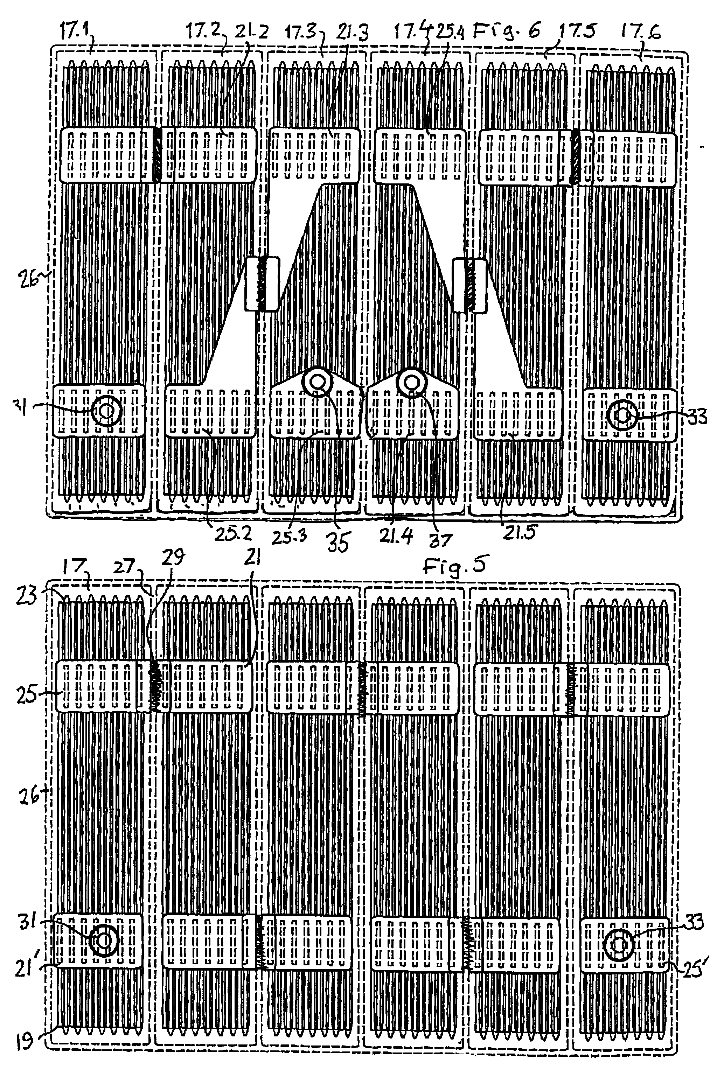

Since the switch device 15 is connected between two interior cells in the battery which consists of several cells connected in series, it is suitable to arrange a connection deviating from the normal case between the sets of plates in the battery cells. In Fig. 5 a starter battery of standard type is shown from above comprising six cells 7 connected in series. The negative plates 19 in each cell are at their top portions connected by a connector strap 21, the positive plates 23 being connected by means of connector straps 25. The connectors 21 and 25 are here alternatingly located and connected at different sides of the top edges of the plates and thus also alternatingly at different sides of the battery vessel 26. Thereby, for a disposition of the battery cells 17 next to each other having simple partition walls 27 between each cell and having the plates in all cells arranged parallel to each other and to the partition walls 27, the positive connector 25 in a battery cell 17 will be located close to and aligned with the negative connector 21 in one adjacent battery cell. For a suitable shape of the connectors 21, 25, so that they protrude somewhat towards an adjacent connector strap, then such a positive connector 25 and a negative connector 21 can be simply connected, e.g. by means of welds indicated at 29. Of course, one connector 21' and 25' respectively in the outermost battery cells 17 is not connected in this way but is provided with more or less cylindrical or weakly conical pole posts 31 and 33 respectively, which are directed upwards, see also the sectional view of Fig. 4.

This disposition of the connectors straps 21 and 25 is however, as has already been observed, not suitable, when a switch device 15 is connected between the two middle cells in such a six cell battery and is located at the front side of the battery, at which the pole posts 31 and 33 for connection to the external terminals 3 and 5 are also located. The connection between the negative and positive sets of plates respectively of the two middle cells will, for the simple zigzag-configuration according to Fig. 5, be located at the other, rear side of the battery.

The connectors of the four middle cells in the battery can then be modified in a way which is illustrated by the view of Fig. 6 illustrating a battery having its lid removed, as seen from above. The battery cells are here designated 17.1, 17.2,..., 17.6, starting with the most negative battery cell. The outermost battery cells 17.1 and 17.6 are here constructed in the same way as in a conventional battery having six cells, that is a conventional lead-acid 12 V battery. The other battery cells are however modified in regard of the connectors. In the second battery cell 17.2 the negative connector 21.2 thereof is not modified. The positive connector 25.2 in this cell has a strap portion, which connects the different positive plates 23 to each other and which corresponds to a connector strap 25 in an ordinary battery. The strap portion is prolonged in a direction towards the centre line of the battery, which extends perpendicular to the sets of plates, and this portion is terminated along this centre line by a portion protruding in the direction of the centre line, of the same type as is provided on the other simple connector straps intended for connection to the connector strap in the adjacent battery cell. In the next battery cell 17.3 the negative connector 21.3 thereof is constructed in the corresponding way and has exactly the same geometrical form as the connector 25.2 in the previous cell.

In the third cell 17.3, further the positive connector 25.3 is not constructed comprising a protrusion portion for connection to the next battery cell but has an upstanding pole post 35 of the same type as is provided on the outermost connectors 31 and 33 respectively in the outermost cells 17.1 and 17.6. This pole post 35 can, as is illustrated in Fig. 6, be located on a portion of the connector 25.3, which protrudes somewhat towards said centre line of the battery. The negative connector 25.4 in the next battery cell 17.4 is constructed in the same way as the positive connector 25.3 in the previous battery cell, which has already been described, and has like it an upwards protruding cylindrical or weakly tapering pole post 37. The positive connector 25.4 in this battery cell and the negative connector 21.5 in the next battery cell, the fifth battery cell 17.5, are constructed in the same way as the connectors 25.3 and 21.3 and comprise a serial connection between the battery cells at the centre line of the battery. The other connectors agree with those provided in a conventional battery according to Fig. 5.

The connector straps 25.3 and 21.4 which carry the middle pole posts 35, 37 and are located adjacent each other enable a simple connection of a switch device 15 therebetween, see also the sectional views of Figs. 2 and 3 illustrating the upper part of the battery.

The middle pole posts 35 and 37 are attached to identical pole pieces 37, see particularly Fig. 3. Such a pole piece 37 connects a pole post 35 or 37 to the switch device 15 and has therefor bolts 41 moulded into it, which are arranged having their heads directed downwards and the threads of the bolts 43 directed upwards. The pole pieces 39 have a top flat surface and holes pass therethrough for receiving a pole post 35 or 37. The pole pieces 41 are, like the connectors for a lead-acid accumulator, made of lead and are welded to the pole posts 35 and 37 with welds indicated at 43 at the upper ends of the pole posts.

A metal plate 45 rests on the top surfaces of the pole pieces 39 and is made of a good thermally conducting and electrically conducting material such as copper or aluminium. The plates 45 are retained in this position by means of nuts 47 threaded on the bolts 41, which pass through suitably made holes in the metal plates 45. The plates 45 have rectangular shapes and are placed in such a way that they have an inner edge parallel to a corresponding inner edge of the other plate and located at a distance therefrom. Thereby the plates 45 are electrically isolated from each other and one terminal of the switch device 15, not shown in Fig. 3, is coupled to one of the plates, the other terminal thereof being coupled to the other one of the plates.

Batteries having different charge capacities can have a different number of plates in each set of plates and therefore the distance between the pole posts 35 and 37 may be different for different battery types. Therefore, the pole pieces 39 are rotatable around the central pole posts 35, 37 before the attachment and connection to the pole posts, so that the bolts 41, which are moulded into the material of the plates 45, can be placed at the same distance for varying battery types. Further the arrangement of the plates 45 against the large top surface of the pole pieces 39 provides a good thermally conducting and electrically conducting connection therebetween. It is particularly valuable in those cases where the switch device 15 itself develops a substantial amount of power, which in some way must be dissipated.

The space around the switch device 15 and its connections to the plates 45 is protected by a metal lid 49, which is made of hardened steel plate and has the shape of a rectangular box which is open in the downward direction. Other parts of the lid 1 and the battery vessel 26 is throughout made of suitable plastics materials. An adhesively attached cover plate 50 forms a lid on the front elevated portion and is thus located above the protective metal lid 49 and above the encapsulated electronic circuits in the block 13. Therefrom metal tongues 52 protrude for among other purposes the communication of the electronic circuits with other electrical devices in a vehicle where the battery can be arranged.

The electronic circuits in the block 13 are through a line 51 connected to the switch device 15 for controlling the on- and off-operation thereof. The electronic circuits in the encapsulated block 13 require in addition a contact with different terminals in the battery, in particularly the exterior connection terminals thereof for monitoring the battery. They are also attached to the terminals of the middle cells, between which the switch device 15 is connected, by means of short lines 53 soldered to the plates 45.

For a connection of the electronic circuits to the exterior terminals 3 and 5 the terminals 3 and 5 are provided with pole pieces 55, see the sectional view of Fig. 4. The pole pieces 55 are provided with through-holes for receiving the pole posts 31 and 33 respectively. At the through-hole the pole pieces 55 are configured as bushings having an outer cylindrical or weakly tapering shape. This outer surface then constitutes the very battery terminal for connection of the battery in e.g. a motor vehicle. Welds 58 connect electrically the pole posts 31 and 35 to the top edge of the sleeve-like part of the pole pieces 55.

The pole pieces 55 are prolonged in a direction towards the centre line of the battery, i.e. they are located in a direction essentially parallel to the plane of the cell plates. They are terminated in a cavity 57 in the lid 1, which extends in the longitudinal direction of the battery adjacent to the channel 10 and extends up to the front elevated portion 11 of the battery, where the switch device 15 and the electronic circuits 13 are arranged. From this inner end in the cavity 57 loose leads 59 extend to the encapsulated block 13, see also Fig. 1. These lines 59 are connected to the pole pieces 55 by providing threaded holes in the innermost parts thereof in the cavity 57, to which screws 61 having underlying contact washers 61 are screwed. By this design of the pole pieces 55 and the longitudinal cavity 57 the pole pieces 55 having an identical shaped can be used for batteries having different sizes and varying numbers of plates in the cells. The screws 61 and the plates 63 are accessible by making the channel 57 open at its exterior ends. Possibly, here snap-in lids may be arranged.

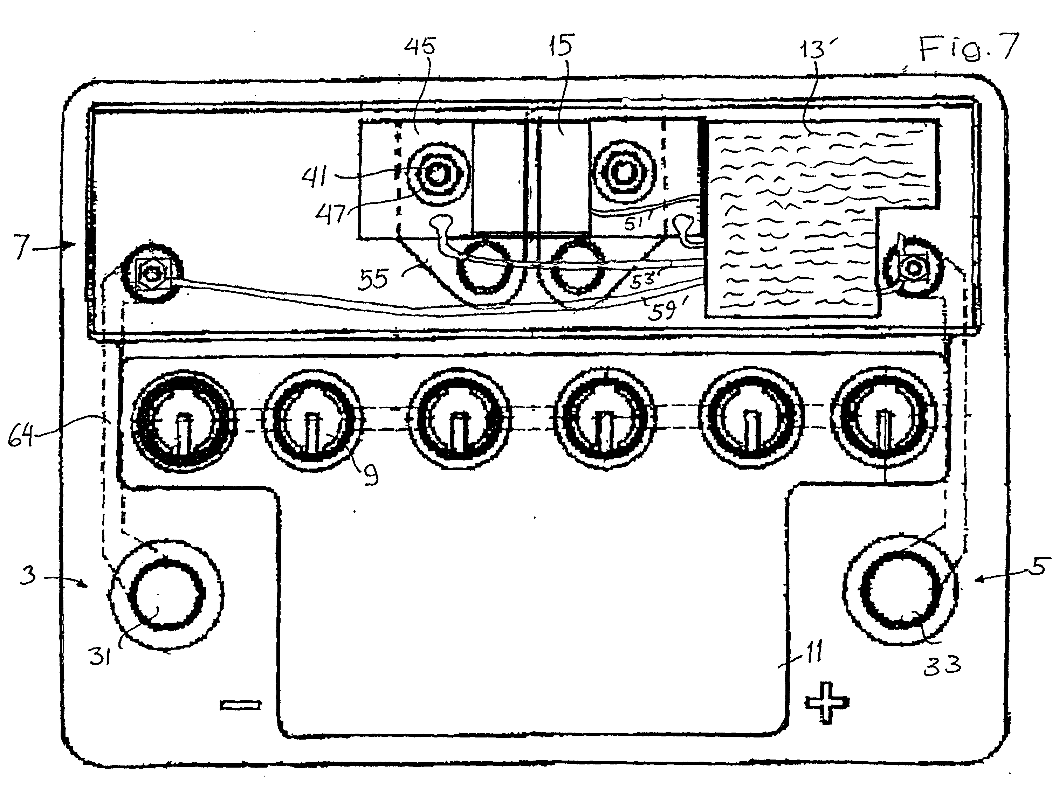

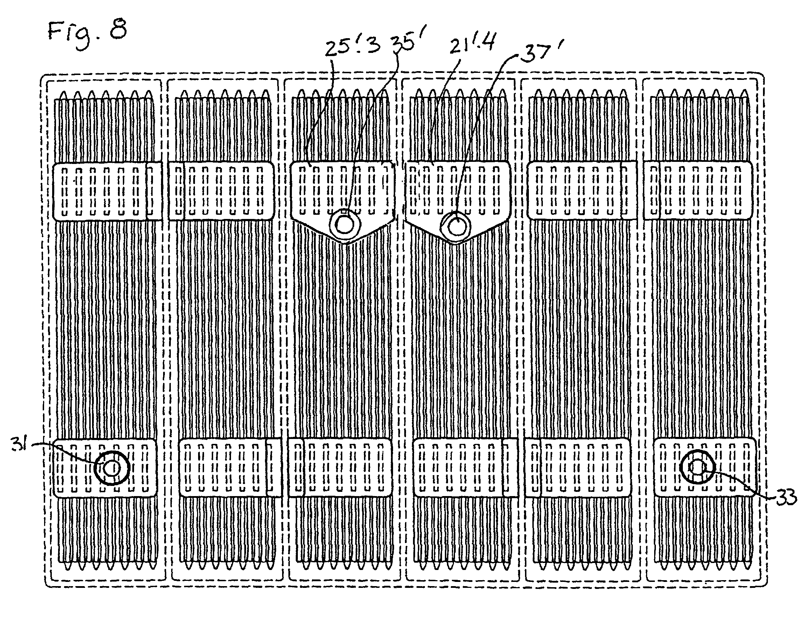

Of course, it is possible to also dispose the switch device 15 and the electronic circuits at the other side, the rear side of the battery, as is illustrated by Figs. 7 and 8. Here only two connectors in the middle cells 17.3 and 17.4 need to be modified compared to a conventional battery. In these middle cells thus those connectors 25'.3 and 21'.4, by means of which the cells are normally connected, are designed in a similar way as the connectors having the pole posts 35 and 37 in the earlier described embodiment. Thus these connectors are configured essentially as normal connectors which lack projections for a serial connection to the next battery cell but possibly comprising a part somewhat protruding towards the centre line of the battery. On this protruding part, then the pole posts 35' and 37' may be located and suitably produced in one part in moulding the connectors 25'.3 and 21'.4.

To the pole posts 35' and 37' of the middle connectors, as above, pole pieces 55 are attached, which can have essentially the same structure as the already described. Electrically and thermally well conducting plates 45 are then attached to the pole pieces 55 as above by means of bolts 41 and nuts 47 and the switch device 15 is located in an electrical and thermal contact with the plates.

To the electronic circuits, which are here moulded in a block 13' that is also located in the rear elevated portion 7 of the lid 1, as above loose leads extend, both a lead 51 from the switch device 15 for control thereof to an on- or an off-state, leads 53' from the plates 45 and finally leads 59' for a contact with the exterior terminals 3 and 5 of the battery. These leads 59' are in their other end screwed to the inner rear end of pole pieces 64, which like the pole pieces 55 are attached to the pole posts 31 and 33 belonging to the outermost connector straps but extend longer in the direction towards the rear side of the battery, beyond its centre line and into the rear elevated portion 7.

## Claims

1. A battery comprising
a plurality of cells (17), which each one comprises positive and negative battery plates (23,19) and positive and negative plate connectors, (25,21) a positive plate connector (25) connecting the positive battery plates (23) in a cell (17) and a negative plate connector (21) connecting the negative battery plates (19) in a cell (17),
electrical series connections connecting adjacent cells connecting plate connectors of adjacent cells so that the cells (17) are electrically connected in series,
exterior terminals (3,5)connected to a plate connector in end cells,
all plates (19,23) in the battery being substantially parallel to each other, the battery having a longitudinal direction perpendicular to the plates and a centre line parallel to the longitudinal direction of the battery and the plate connectors (21,25) being located along two lines at each side of and parallel to the centre line,
the electrical serial connection of a first cell and a second adjacent comprising an electrically controlled switch means (15), the switch means (15) being connected to the positive plate connector (21) of the first cell and to the negative plate connector (25) of the second cell,
**characterized in that** the plate connectors (21,25) of the first and second cells which connectors are not connected to the switch means (15) have laterally protruding portions extending towards the centre line and at their ends have electrical series connections to plate connectors in a third cell and in a fourth cell respectively, the third cell being adjacent to the first cell and and the fourth cell being adjacent to the second cell, all of the first, second, third and fourth cells being different cells, said plate connectors (21,25) in the third and fourth cells similarly having laterally protruding portions extending towards the centre line, the protruding portion of the plate connector of the third cell having a direction opposite that of the protruding portion of the plate connector of the first cell and the protruding portion of the plate connector of the fourth cell having a direction opposite that of the protruding portion of the plate connector of the second cell, the series connection between the first cell and the third cell and between the second cell and the fourth cell being connected to the ends of the protruding portions of the plate connectors in the respective cells, the protruding portions allowing the exterior terminals (3,5) and said positive and negative plate connectors (21,25) to be arranged at the same side of the centre line.

2. A battery according to claim 1, **characterized in that** it comprises a number of cells (17), the number being a multiple of six, the first and second cells then being the two middle adjacent cells.

3. A battery according to any of claims 1 - 2, **characterized in that** all plate connectors (21,25) of the battery cells (17) except the those of the first and second cells and one plate connector of the third and fourth cells are connected to each other in a zigzag pattern.

## Patentansprüche

1. Batterie mit:
mehreren Zellen (17) jeweils mit positiven und negativen Batterieplatten (23,19) sowie positiven und negativen Plattenverbindungsteilen (25,21), wobei ein positives Plattenverbindungsteil (25) die positiven Batterieplatten (23) in einer Zelle (17) verbindet und ein negatives Plattenverbindungsteil (21) die negativen Batterieplatten (19) in einer Zelle verbindet,
elektrischen Reihenverbindungen, die benachbarte Zellen verbinden, welche die Plattenverbindungen benachbarter Zellen verbinden, so dass die Zellen (17) elektrisch in Reihe geschaltet sind,
außenliegende Anschlüsse (3,5) die mit einem Plattenverbindungsteil in Endzellen verbunden sind,
wobei sämtliche Platten (19,23) in der Batterie im wesentlichen parallel zueinander angeordnet sind und die Batterie eine rechtwinklig zu den Platten verlaufende Längsrichtung und eine parallel zu der Längsrichtung der Batterie verlaufende Mittellinie aufweist und die Plattenverbindungsteile (21,25) entlang zweier Linien auf jeder Seite und parallel zu der Mittellinie angeordnet sind,
die elektrischen Reihenverbindungen einer ersten Zelle und einer zweiten benachbarten Zelle eine elektrisch gesteuerte Schaltereinrichtung (15) aufweisen, die mit dem positiven Plattenverbindungsteil (21) der ersten Zelle und dem negativen Plattenverbindungsteil (25) der zweiten Zelle verbunden ist,
**dadurch gekennzeichnet, dass**
die Plattenverbindungsteile (21,25) der ersten und zweiten Zellen, die nicht mit der Schaltereinrichtung (15) verbunden sind, seitlich vorstehende Teile aufweisen, die in Richtung der Mittellinie verlaufen und an ihren Enden elektrische Reihenverbindungen zu den Plattenverbindungsteilen in einer dritten Zelle bzw. vierten Zelle aufweisen, wobei die dritte Zelle der ersten Zelle benachbart ist und die vierte Zelle der zweiten Zelle benachbart ist und sämtliche der ersten, zweiten, dritten und vierten Zellen unterschiedliche Zellen sind, die Plattenverbindungsteile (21,25) in den dritten und vierten Zellen in ähnlicher Weise mit seitlich vorstehenden Teilen versehen sind, die in Richtung der Mittellinie verlaufen, der vorstehende Teil des Plattenverbindungsteils der dritten Zelle eine der Richtung des vorstehenden Teils des Plattenverbindungsteils der ersten Zelle entgegengesetzte Richtung und der vorstehende Teil des Plattenverbindungsteils der vierten Zelle eine der Richtung des vorstehenden Teils des Plattenverbindungsteils der zweiten Zelle entgegengesetzte Richtung aufweist, die Reihenverbindungen zwischen der ersten Zelle und der dritten Zelle und zwischen der zweiten Zelle und der vierten Zelle mit den Enden der vorstehenden Teile der Plattenverbindungsteile in den jeweiligen Zellen verbunden sind, und es die vorstehenden Teile ermöglichen, dass die außenliegenden Anschlüsse (3,5) und die positiven und negativen Plattenverbindungsteile (21, 25) auf derselben Seite der Mittellinie angeordnet sind.

2. Batterie nach Anspruch 1, **dadurch gekennzeichnet, dass** diese eine Anzahl von Zellen (17) aufweist, die ein Vielfaches von sechs ist, wobei die ersten und zweiten Zellen dann die beiden mittleren benachbarten Zellen sind.

3. Batterie nach einem der Ansprüche 1-2, **dadurch gekennzeichnet, dass** sämtliche Plattenverbindungsteile (21,25) der Batteriezellen (17), mit Ausnahme derjenigen der ersten und zweiten Zellen, und ein Plattenverbindungsteil der dritten und vierten Zellen in einem Zickzackmuster miteinander verbunden sind.

## Revendications

1. Batterie comprenant
une pluralité d'éléments (17), dont chacun comprend des plaques de batterie positives et négatives (23, 19) et des connecteurs de plaques positives et négatives (25, 21), un connecteur de plaques positives (25) reliant les plaques de batterie positives (23) dans un élément (17) et un connecteur de plaques négatives (21) reliant les plaques de batterie négatives (19) dans un élément (17),
des connexions électriques en série reliant des éléments adjacents en reliant les connecteurs de plaques des éléments adjacents de sorte que les éléments (17) soient électriquement reliés en série,
des bornes extérieures (3, 5) reliées à un connecteur de plaques dans les éléments d'extrémité,
toutes les plaques (19, 23) dans la batterie étant sensiblement parallèles les unes aux autres, la batterie présentant une direction longitudinale perpendiculaire aux plaques et une ligne centrale parallèle à la direction longitudinale de la batterie et les connecteurs de plaques (21, 25) étant situés suivant deux lignes de chaque côté de la ligne centrale et qui sont parallèles à la ligne centrale,
la connexion électrique en série d'un premier élément et d'un second élément adjacents comprenant un moyen de commutateur à commande électrique (15), le moyen de commutateur (15) étant relié au connecteur de plaques positives (21) du premier élément et au connecteur de plaques négatives (25) du second élément,
**caractérisée en ce que** les connecteurs de plaques (21, 25) des premier et second éléments, lesquels connecteurs ne sont pas reliés au moyen de commutateur (15), comportent des parties faisant latéralement saillie s'étendant vers la ligne centrale et comportent à leurs extrémités des connexions électriques en série aux connecteurs de plaques d'un troisième élément et d'un quatrième élément respectivement, le troisième élément étant contigu au premier élément et le quatrième élément étant contigu au second élément, la totalité des premier, second, troisième et quatrième éléments constituant des éléments différents, lesdits connecteurs de plaques (21, 25) dans les troisième et quatrième éléments comportant de façon similaire des parties faisant latéralement saillie s'étendant vers la ligne centrale, la partie saillante du connecteur de plaques du troisième élément ayant une direction opposée à celle de la partie saillante du connecteur de plaques du premier élément et la partie saillante du connecteur de plaques du quatrième élément ayant une direction opposée à celle de la partie saillante du connecteur de plaques du second élément, la connexion en série entre le premier élément et le troisième élément et entre le second élément et le quatrième élément étant reliée aux extrémités des parties saillantes des connecteurs de plaques des éléments respectifs, les parties saillantes permettant que les bornes extérieures (3, 5) et lesdits connecteurs de plaques positives et négatives (21, 25) soient disposés du même côté de la ligne centrale.

2. Batterie selon la revendication 1, **caractérisée en ce qu'**elle comprend un certain nombre d'éléments (17), le nombre étant un multiple de six, les premier et second éléments étant alors les deux éléments contigus du milieu.

3. Batterie selon l'une quelconque des revendications 1 à 2, **caractérisée en ce que** tous les connecteurs de plaques (21, 25) des éléments de la batterie (17) à l'exception de ceux des premier et second éléments et un connecteur de plaques des troisième et quatrième éléments sont reliés les uns aux autres suivant un motif en zigzag.
